Europäisches Patentamt

European Patent Office

Office européen des brevets

(19)

(11) Veröffentlichungsnummer: **0 157 459 B1**

# EUROPÄISCHE PATENTSCHRIFT

(45) Veröffentlichungstag der Patentschrift: **10.04.91**

(51) Int. Cl.5: **H03H 11/24**

(21) Anmeldenummer: **85200489.4**

(22) Anmeldetag: **01.04.85**

(54) **Logarithmische Potentiometerschaltung.**

(30) Priorität: **04.04.84 DE 3412532**

(43) Veröffentlichungstag der Anmeldung:
**09.10.85 Patentblatt 85/41**

(45) Bekanntmachung des Hinweises auf die
Patenterteilung:
**10.04.91 Patentblatt 91/15**

(84) Benannte Vertragsstaaten:
**DE FR GB IT SE**

(56) Entgegenhaltungen:

**TOUT L'ELECTRONIQUE, Nr. 419, März 1977,
Seiten 55-58, Paris, FR; R. HOUZE: "Etude
pratique du circuit "N.I.C.""**

(73) Patentinhaber: **Philips Patentverwaltung
GmbH
Wendenstrasse 35 Postfach 10 51 49
W-2000 Hamburg 1(DE)DE**

Patentinhaber: **N.V. Philips' Gloeilampenfabrieken
Groenewoudseweg 1
NL-5621 BA Eindhoven(NL)FR GB IT SE**

(72) Erfinder: **Koken, Klaus
Am Sooren 100
W-2000 Hamburg 73(DE)**

(74) Vertreter: **Auer, Horst, Dipl.-Ing. et al
Philips Patentverwaltung GmbH Wendenstrasse 35 Postfach 10 51 49
W-2000 Hamburg 1(DE)**

EP 0 157 459 B1

**Beschreibung**

Die Erfindung bezieht sich auf eine logarithmische Potentiometerschaltung.

Aus TOUTE L'ELECTRONIQUE, Nr. 419, März 1977, Seiten 55-58, Paris, FR; R. Houze: "Etude pratique du circuit "N.I.C."", Figur 5, ist eine Schaltung bekannt, bei der ein linear einstellbares Widerstandselement mit einer zweipoligen Schaltungsanordnung mit einem negativen ohm'schen Widerstandswert parallel geschaltet ist. Das einstellbare Widerstandselement dieser Schaltungsanordnung ist jedoch lediglich dazu vorgesehen, an einem bestimmten Punkt der Schaltung eine bestimmte Spannung einzustellen, die zu Meßzwecken beispielsweise an einen Negativimpedanzkonverter anzulegen ist, der die zweipolige Schaltungsanordnung bilden kann. Es bildet somit keine logarithmische Potentiometerschaltung.

Ferner sind logarithmische Potentiometer allgemein bekannt und beispielsweise in "Baiers Elektronik Lexikon", Franksche Verlagsbuchhandlung Stuttgart, 1974, auf S. 406 beschrieben. Werden eine Anschlußklemme und der Abgriff eines logarithmischen Potentiometers elektrisch miteinander verbunden, ergibt sich ein einstellbares ohm'sches Widerstandselement mit exponentieller Widerstandskennlinie, die sich als Gerade darstellen läßt, wenn der ohm'sche Widerstand auf der Ordinate des Kennliniendiagrammes logarithmisch aufgetragen ist. Derartige Potentiometer können als Schichtpotentiometer oder als Drahtpotentiometer ausgebildet sein. Die Herstellung von logarithmischen Drahtpotentiometern mit einer genau vorgebbaren, exponentiellen Kennlinie ist jedoch relativ teuer, da hierbei hochwertiger Widerstandsdraht auf einem präzise hergestellten, isolierenden Grundkörper gewickelt wird. Auch Schichtpotentiometer, deren tatsächliche Kennlinie einer vorgegebenen Kennlinie vollständig entspricht, sind nur mit großem technischen Aufwand herstellbar.

Aufgabe der vorliegenden Erfindung ist es, eine preisgünstige Potentiometerschaltung mit genau vorgebbarer, näherungsweise logarithmischer Kennlinie zu schaffen.

Diese Aufgabe wird bei einer logarithmischen Potentiometerschaltung durch die Merkmale des Anspruchs 1 gelöst.

Die Potentiometerschaltung nach der Erfindung besteht lediglich aus einem linear einstellbaren Widerstandselement, das relativ preisgünstig herstellbar ist, und aus einer einfachen zweipoligen Schaltungsanordnung mit negativem ohm'schen Widerstandswert, die beispielsweise als Verstärker ausgebildet ist, dessen Kennlinie über die Auswahl der im Verstärker enthaltenen passiven und aktiven Bauelemente genau vorgebbar ist. An den Eingangsklemmen der Schaltungsanordnung ist hierbei ein negativer ohm'scher Widerstandswert meßbar, so daß sich der Widerstand der Parallelschaltung aus einstellbarem Widerstandselement und zweipoliger Schaltungsanordnung näherungsweise exponentiell verändert, wenn das Widerstandselement linear verstellt wird.

Eine vorteilhafte Ausgestaltung der Erfindung ist dadurch gekennzeichnet, daß die Schaltungsanordnung als Negativimpedanzkonverter ausgebildet ist, dessen Eingangstor mit einer Anschlußklemme des Widerstandselementes und dessen Ausgangstor über einen festen ohmschen Widerstand mit der anderen Anschlußklemme des Widerstandselementes verbunden ist. Negativimpedanzkonverter (vgl. Tietze, Schenk; Halbleiter-Schaltungstechnik; 4. Auflage; 1978, Springer-Verlag; S. 255 bis 258) sind einfach aufgebaut, so daß sie relativ preisgünstig herstellbar sind.

Ein Ausführungsbeispiel der Erfindung wird im folgenden anhand der Zeichnung beschrieben. Es zeigen:

Fig. 1 eine einen Negativimpedanzkonverter enthaltende logarithmische Potentiometerschaltung.

Fig. 2 die Kennlinie der Potentiometerschaltung.

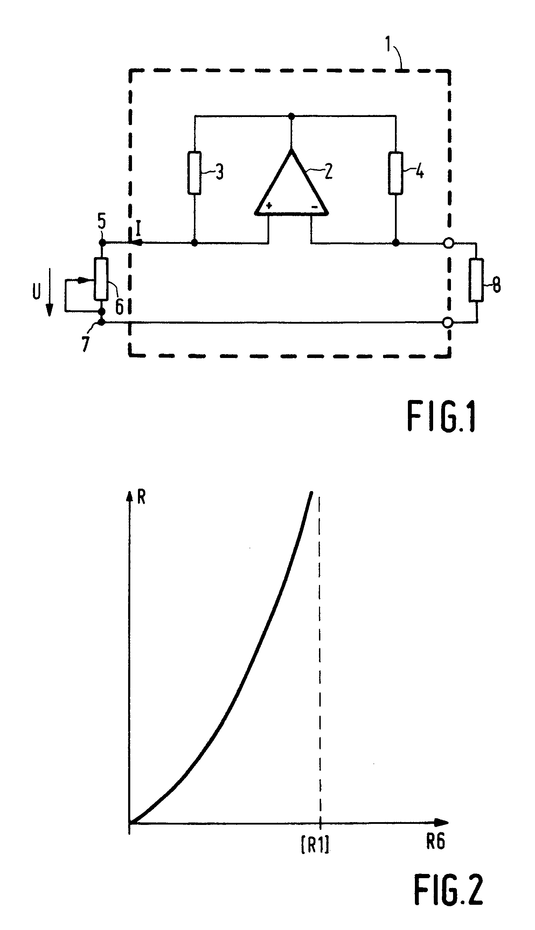

Ein als Negativimpedanzkonverter 1 ausgebildeter Verstärker ist in Fig. 1 gestrichelt dargestellt und besteht aus einem Operationsverstärker 2, dessen Ausgang über einen ersten Widerstand 3 mit dem nicht invertierenden Eingang und über einen zweiten Widerstand 4 mit dem invertierenden Eingang des Operationsverstärkers 2 verbunden ist.

Außerdem ist der nicht-invertierende Eingang des Operationsverstärkers 2 mit einer Anschlußklemme 5 eines Widerstandselementes 6 mit linear einstellbarem ohm'schen Widerstandswert verbunden, dessen andere Anschlußklemme 7 über einen festen ohm'schen Widerstand 8 mit dem invertierenden Eingang des Operationsverstärkers 2 verbunden ist.

Wird an die Klemmen 5 und 7 eine Spannung U angelegt, fließt im Negativimpedanzkonverter 1 ein Strom I in Richtung des eingezeichneten Pfeiles. Der Widerstand R1 des Negativimpedanzkonverters 1 ist somit negativ und ergibt sich aus der Beziehung $R1 = - R8 \times R3/R4$. Hierbei bedeuten R3 den Wert des ersten Widerstandes 3, R4 den Wert des zweiten Widerstandes 4 und R8 den Wert des festen ohm'schen Widerstandes 8.

Der an den Klemmen 5 und 7 meßbare Widerstandswert R der Parallelschaltung aus Negativimpedanzkonverter 1 und Widerstandselement 6 ergibt sich nach der Beziehung $R = |R1| \times R6 / (|R1| - R6)$, wobei R6 den Wert des Widerstandselementes 6 bedeutet.

Wie sich nach dieser Beziehung der Widerstandswert R der Potentiometerschaltung in Abhängigkeit des Widerstandswertes R6 des Widerstandselementes 6 verändert, ist in Fig. 2 dargestellt. Hieraus ist ersichtlich, daß bei einer linearen Vergrößerung des Widerstandswertes R6 der ohm'sche Widerstand R der Potentiometerschaltung näherungsweise exponentiell zunimmt. Außerdem muß der Widerstand R6 kleiner als der sich aus dem Quotienten von Spannung U zu Strom I ergebende Wert |R1| sein, da der Widerstand R der Potentiometerschaltung unendlich groß wird, wenn der Widerstand R6 des Widerstandselementes 6 den Wert |R1| annimmt.

Eine experimentell erprobte Potentiometerschaltung enthält einen Operationsverstärker 2 vom Typ TL072ACP-00 von Texas Instruments, einen ersten Widerstand 3 von 8,94 kOhm, einen zweiten Widerstand 4 von 5,11 kOhm, einen festen ohm'schen Widerstand 8 von 10 kOhm und ein Widerstandselement 6, dessen Wert von 4 kOhm bis 14 kOhm linear einstellbar ist. An den Anschlußklemmen 5 und 7 weist diese Potentiometerschaltung einen ohm'schen Widerstand auf, der sich von ca. 5 kOhm bis ca. 70 kOhm verändern läßt.

## Ansprüche

1. Logarithmische Potentiometerschaltung bestehend aus einer Paralleschaltung eine einstellbaren ohm'schen Widerstandselements (6) mit eines linear verstellbaren Widerstandswert (R6) und einer zweipoligen Schaltungsanordnung (1) mit negativem ohm'schen Widerstandswert, wobei sich der an den Verbindungspunkten (5,7) der Parallelschaltung des Widerstandselements (6) und der zweipoligen Schaltungsanordnung (1) gebildete Widerstand bei linearer Verstellung des Widerstandswert näherungsweise exponentiell verhält.

2. Logarithmische Potentiometerschaltung nach Anspruch 1, dadurch gekennzeichnet, daß die Schaltungsanordnung als Negativimpedanzkonverter (1) ausgebildet ist, dessen Eingangstor mit einer Anschlußklemme (5) des Widerstandselementes (6) und dessen Ausgangstor über einen festen ohm'schen Widerstand (8) mit der anderen Anschlußklemme (7) des Widerstandselementes (6) verbunden ist.

## Claims

1. A logarithmic potentiometer arrangement comprising a variable ohmic resistance element (6), whose resistance (R6) is linearly variable, arranged in parallel with a two-terminal circuit (1) having a negative ohmic resistance, wherein the resistance obtained across the terminals (5, 7) of the parallel arrangement of the resistance element (6) and the two-terminal circuit (1) varies substantially exponentially in the case a linear variation of the resistance value.

2. A logarithmic potentiometer arrangement as claimed in Claim 1, characterized in that the circuit is constructed as a negative-impedance converter (1) having its input port connected to one terminal (5) of the resistance element (6) and having its output port connected to the other terminal (7) of the resistance element (6) through a fixed ohmic resistor (8).

## Revendications

1. Potentiomètre logarithmique constitué par un montage en parallèle d'un élément de résistance ohmique réglable 6 présentant une valeur de résistance linéairement réglable (R6) et un dispositif de circuit bipolaire (1) présentant une valeur de résistance ohmique négative, la résistance formée dans le cas d'une variation de la valeur de résistance aux points de connexion (5, 7) du montage en parallèle de l'élément de résistance (6) et du dispositif de circuit bipolaire (1) se comportant d'une façon approximativement exponentielle.

2. Potentiomètre logarithmique selon la revendication 1, caractérisé en ce que le dispositif de circuit est sous forme d'un convertisseur d'impédance négative 1, dont la porte d'entrée est connectée à une borne de connexion (5) de l'élément de résistance (6) et dont la porte de sortie est connectée à l'autre borne de connexion (7) de l'élément de résistance (6) par l'intermédiaire d'une résistance ohmique fixe (8).

FIG.1

FIG.2